# EUROPEAN PATENT SPECIFICATION

(11) **EP 3 076 774 B1**
(45) Date of publication and mention of the grant of the patent: **10.10.2018**
(21) Application number: 15162400.4
(22) Date of filing: 02.04.2015
(51) Int. Cl.: H05K 7/14

(54) **SLIDE RAIL ASSEMBLY**
SCHIENENANORDNUNG
ENSEMBLE DE RAIL DE GLISSEMENT

(43) Date of publication of application: 05.10.2016
(73) Proprietor: King Slide Works Co., Ltd., Kaohsiung City, Taiwan 821 (TW); King Slide Technology Co., Ltd., 82151 Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Lu, Hsiao-Han, Kaohsiung City (TW); Wang, Chun-Chiang, Kaohsiung City (TW)
(74) Representative: Becker Kurig Straus

(56) References cited:
- EP-A2- 2 632 240
- US-A1- 2010 008 608
- US-B1- 7 746 667

## Description

### Field of the Invention

The present invention is related to a slide rail assembly.

### Background of the Invention

A slide rail assembly may comprise an outer rail, a middle rail and an inner rail movably connected to each other for being extended or retracted. Both ends of the outer rail can be attached to a rack for supporting the slide rail assembly. The middle rail is movably connected between the outer rail and the inner rail for supporting the inner rail when the inner rail is pulled out. The inner rail can carry a device, such as a chassis, such that the slide rail assembly can allow the chassis to be stored in the rack or drawn out from the rack.

Generally, a cable management device is provided on the slide rail assembly for securing cables between the rack and the chassis. When the travel distance of the slide rail assembly is increased, a longer cable management device is required. In order to prevent the cable management device from sagging downward, U.S. Pat. No. 7,746,667 discloses a slide rail assembly comprising a support member for supporting a cable management device. However, the support member may increase complexity of structure of the slide rail assembly, and further increase difficulty for installing the slide rail assembly.

Note that, document US 2010/0086608 discloses a slide assembly associated with a foldable cable management arm. However, the rear brace of the cable management arm is secured to the outer rail. The rear brace of the cable management arm is not movable in response to movement of the inner rail.

Document EP 2632240 A2 discloses the features of the preamble of claim 1.

### Summary of the Invention

This in mind, the present invention aims at providing a slide rail assembly capable of allowing both ends of a cable management device to move with a chassis when the chassis is drawn out.

This is achieved by a slide rail assembly according to claim 1. The dependent claims pertain to corresponding further developments and improvements.

As will be seen more clearly from the detailed description following below, the claimed slide rail assembly includes a first rail, a first connection base, a second rail and a second connection base. The first rail defines a first passage along a first direction. The first connection base is movably connected to the first rail and is movable relative to the first rail between a first position and a second position in the first passage. The second rail is capable of moving relative to the first rail along the first direction. The second connection base is connected to the second rail.

As will be seen more clearly from the detailed description following below, the claimed slide rail assembly includes a first rail, a first connection base, a second rail and a second connection base. The first rail comprises two first sidewalls and a first lateral wall connected between the two first sidewalls. A first passage is defined by the two first sidewalls and the first lateral wall along a first direction. The first connection base is movably connected to the first rail and is movable relative to the first rail in the first passage, and the first connection base is configured to connect to a first arm of a cable management device. The second rail is capable of moving relative to the first rail along the first direction. The second connection base is connected to the second rail, and configured to connect to a second arm of the cable management device movably connected to the first arm, wherein when the second rail is moved a predetermined distance outward along the first direction, the first connection base is pulled by the second rail through the cable management device to move from a first position toward a second position in the first passage.

As will be seen more clearly from the detailed description following below, the claimed slide rail assembly is configured to install a chassis on a rack, and includes a first rail, a first bracket, a second bracket, a first connection base, a middle rail, a second rail and a second connection base. The first rail comprises two first sidewalls and a first lateral wall connected between the two first sidewalls. A first passage is defined by the two first sidewalls and the first lateral wall along a first direction. The first bracket is connected to a first end of the first rail, and configured to attach to a first post of the rack. The second bracket is connected to a second end of the first rail, and configured to attach to a second post of the rack. The first connection base is movably connected to the first rail and is movable relative to the first rail in the first passage, and the first connection base is configured to connect to a first arm of a cable management device. The middle rail is movably connected to the first rail and is movable relative to the first rail in the first passage, and the middle rail comprises two second sidewalls and a second lateral wall connected between the two second sidewalls. A second passage is defined by the two second sidewalls and the second lateral wall along the first direction. The second rail is movably connected to the middle rail and is movable relative to the middle rail in the second passage, the chassis being mounted on the second rail. The second connection base is connected to the second rail, and configured to connect to a second arm of the cable management device movably connected to the first arm, wherein when the second rail is moved a predetermined distance outward along the first direction, the first connection base is pulled by the second rail through the cable management device to move from a first position toward a second position in the first passage.

### Brief Description of the Drawings

In the following, the invention is further illustrated by way of example, taking reference to the accompanying drawings thereof:
FIG. 1 is a diagram showing a slide rail assembly of an embodiment of the present invention;
FIG. 2 is an exploded view of the slide rail assembly of an embodiment of the present invention;
FIG. 3 is a diagram showing the slide rail assembly of an embodiment of the present invention configured to install a chassis onto a rack;
FIG. 4 is a diagram showing a folded cable management device when the chassis is stored in the rack;
FIG. 5 is a diagram showing an end of the first arm of the cable management device located at a position on the outer rail;
FIG. 6 is a diagram showing the end of the first arm of the cable management device located at another position on the outer rail;
FIG. 7 and FIG. 8 are diagrams showing the first connection base comprising an elastic arm for engaging with the middle rail;
FIG. 9 is a diagram showing the first connection base engaged with the middle rail;
FIG. 10 is a diagram showing the first connection base released from the middle rail;
FIG. 11 is a diagram showing the supporting base located at a position on the first bracket;
FIG. 12 is a diagram showing the supporting base located at another position on the first bracket; and
FIG. 13 is a cross-sectional view of the slide rail assembly along line 1-1 of FIG. 1 according to an embodiment of the present invention.

### Detailed Description

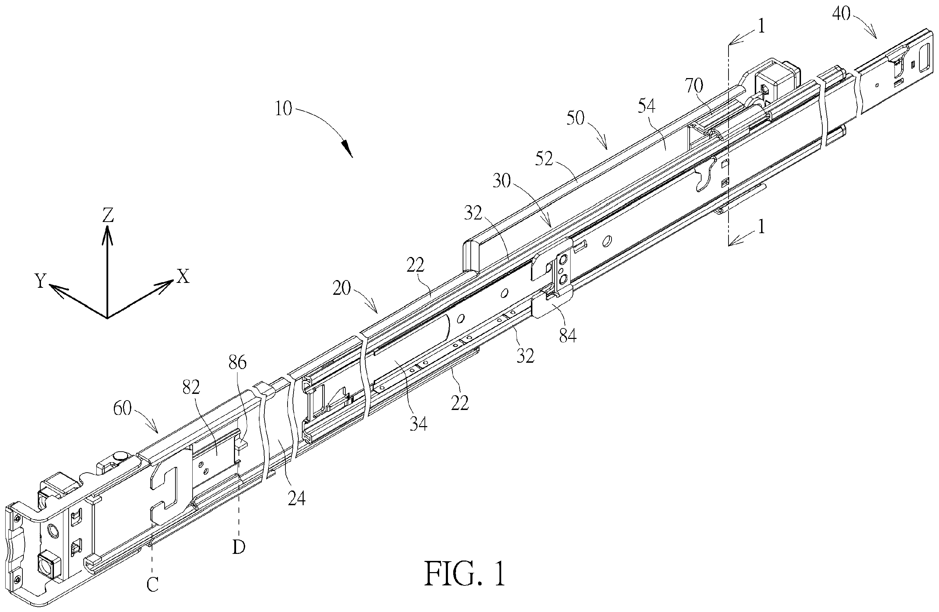

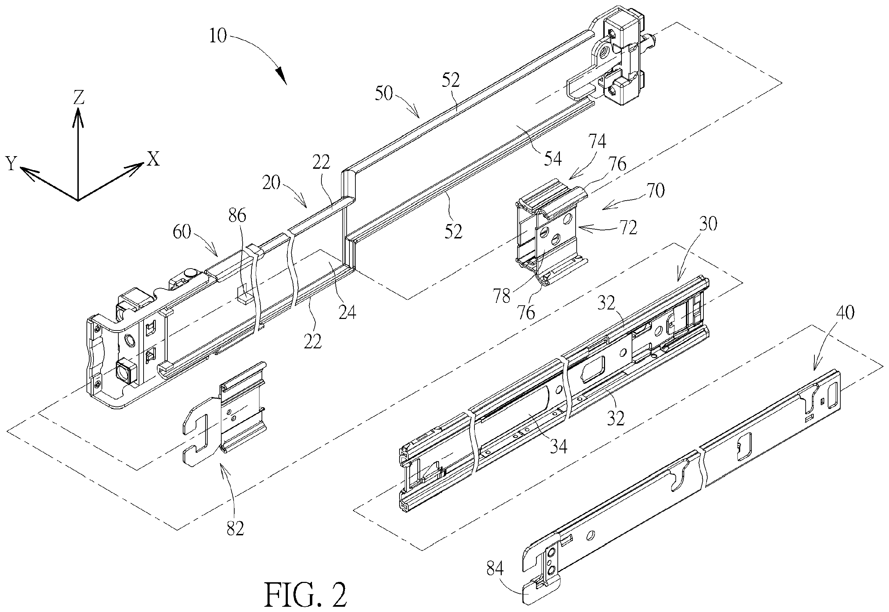

FIG. 1 is a diagram showing a slide rail assembly of an embodiment of the present invention. FIG. 2 is an exploded view of the slide rail assembly of an embodiment of the present invention. The slide rail assembly 10 comprises an outer rail 20, a middle rail 30, an inner rail 40, a first connection base 82 and a second connection base 84. The outer rail 20 comprises two first sidewalls 22 and a first lateral wall 24 connected between the two first sidewalls 22. A first passage is defined by the two first sidewalls 22 and the first lateral wall 24 along a first direction X (a longitudinal direction of the slide rail assembly 10). The middle rail 30 is movably connected to the outer rail 20 and is movable relative to the outer rail 20 in the first passage. The middle rail 30 comprises two second sidewalls 32 and a second lateral wall 34 connected between the two second sidewalls 32. A second passage is defined by the two second sidewalls 32 and the second lateral wall 34 along the first direction X. The inner rail 40 is movably connected to the middle rail 30 and is movable relative to the middle rail 30 in the second passage. The first connection base 82 is movably connected to the outer rail 20 and is movable relative to the outer rail 20 between a position C and a position D in the first passage. The second connection base 84 is connected to the inner rail 40.

The slide rail assembly 10 further comprises a first bracket 50 and a second bracket 60. The first bracket 50 is connected to a first end of the outer rail 20. The second bracket 60 is connected to a second end of the outer rail 20.

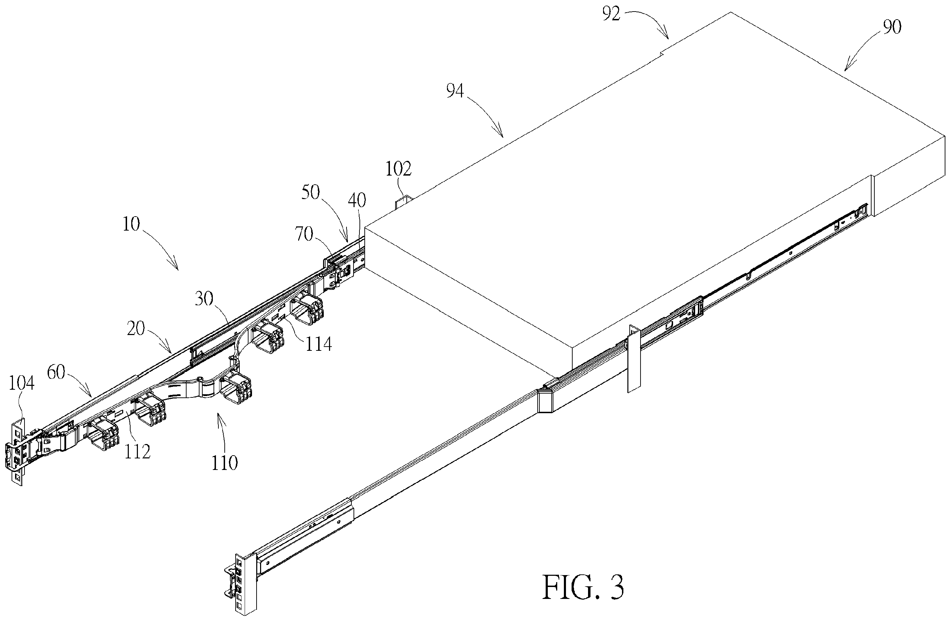

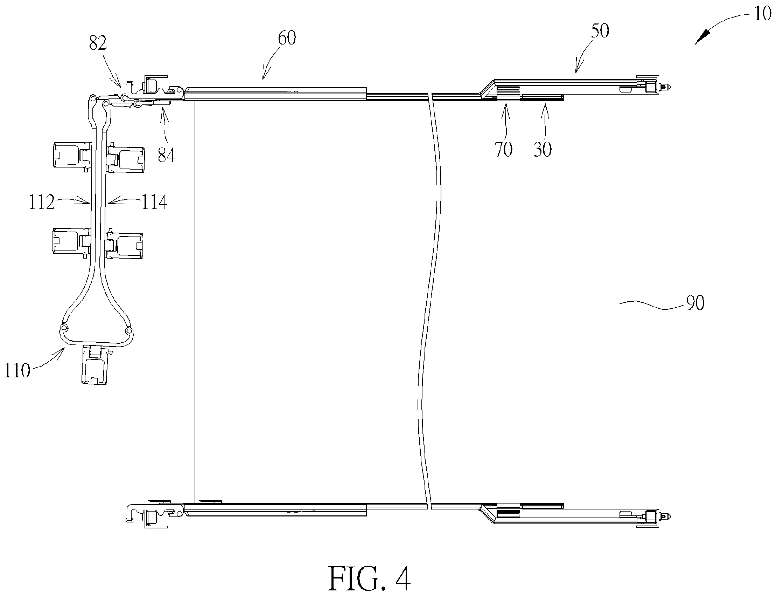

Referring to FIG. 3, FIG. 3 is a diagram showing the slide rail assembly of an embodiment of the present invention configured to install a chassis onto a rack. The first bracket 50 is configured to attach to a first post 102 of the rack, and the second bracket 60 is configured to attach to a second post 104 of the rack, such that the slide rail assembly 10 can be installed on the rack. Moreover, a chassis 90 can be mounted on the inner rail 40, such that the slide rail assembly 10 can allow the chassis 90 to be stored in the rack or drawn out from the rack. The chassis 90 comprises a first portion 92 and a second portion 94. The first portion 92 is wider than the second portion 94, and a side of the second portion 94 is mounted on the inner rail 40. In addition, the first connection base 82 is configured to connect to a first arm 112 of a cable management device 110, and the second connection base is configured to connect to a second arm 114 of the cable management device 110 movably connected to the first arm 112. Wherein, the first arm 112 and the second arm 114 can be pivotally connected to each other. The cable management device 110 can support cables connecting to a device arranged on the chassis 90. Moreover, as shown in FIG. 4, when the chassis 90 is stored in the rack, the cable management device 110 is folded.

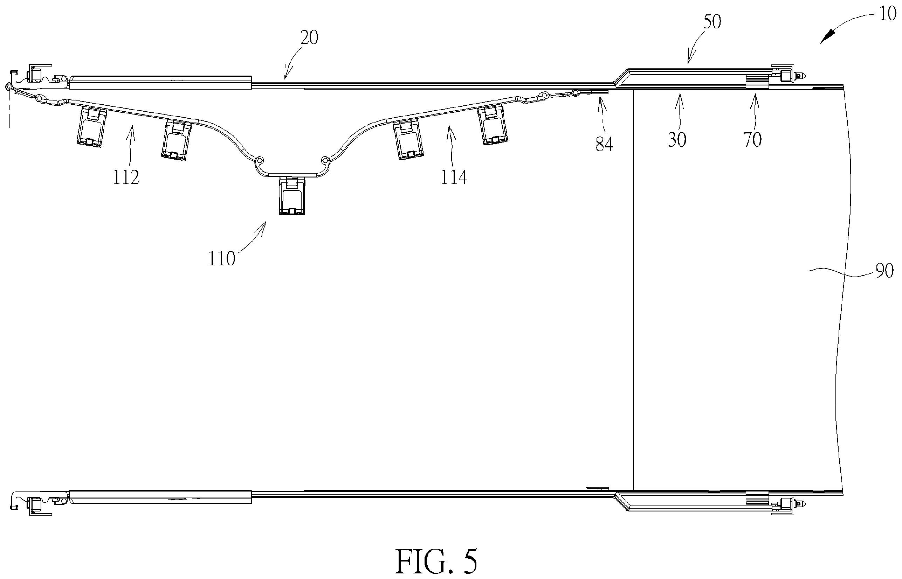

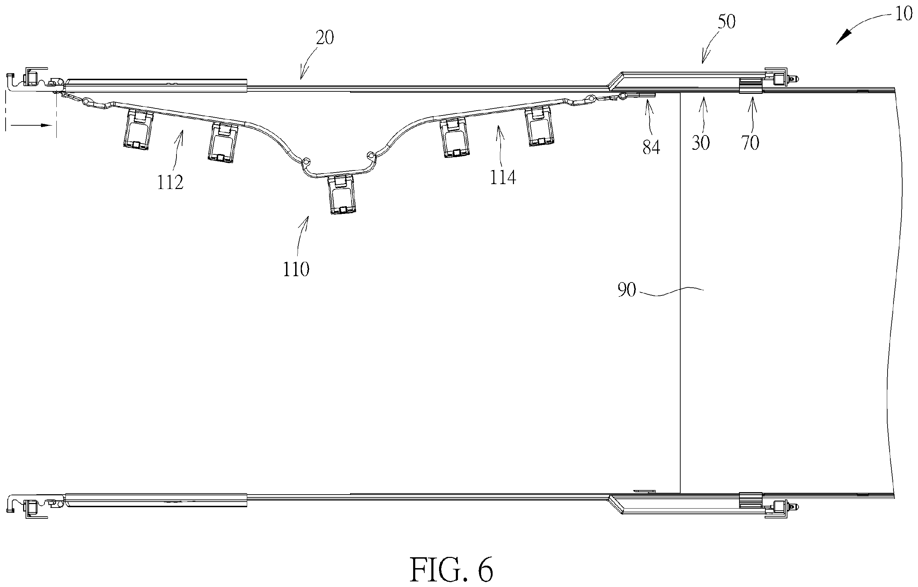

According to the above arrangement, when the inner rail 40 is moved a predetermined distance outward along the first direction X, the first connection base 82 can be pulled by the inner rail 40 through the cable management device 110 to move in the first passage. As shown in FIG. 5 and FIG. 6, an end of the first arm 112 of the cable management device 110 can move on the slide rail assembly 10 when the chassis 90 is drawn out. In other words, both ends of the cable management device 110 can move with the inner rail 40 when the inner rail 40 is pulled out. Therefore, lengths of the first and second arms 112, 114 of the cable management device 110 can be reduced, such that a support member for supporting the cable management device 110 is not needed when the travel distance of the slide rail assembly 10 is increased.

Referring to FIG. 1 again, according to an embodiment of the present invention, the outer rail 20 can further comprises a stopper 86 for stopping the first connection base 82 when the first connection base 82 arrives at the position D. However, in other embodiment of the present invention, the stopper 86 is not necessary.

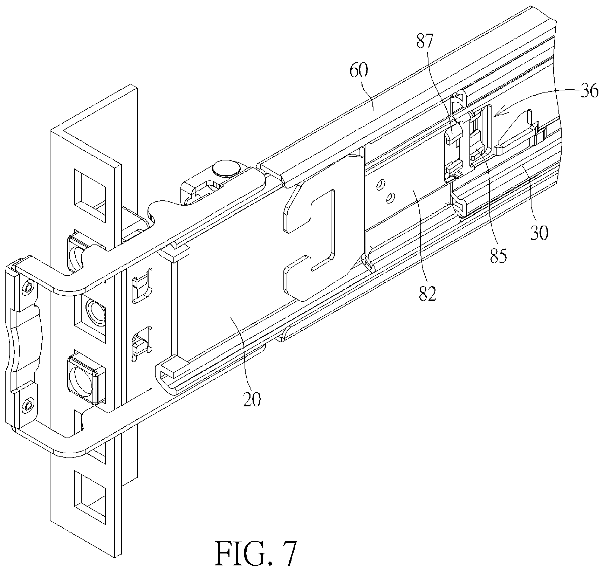

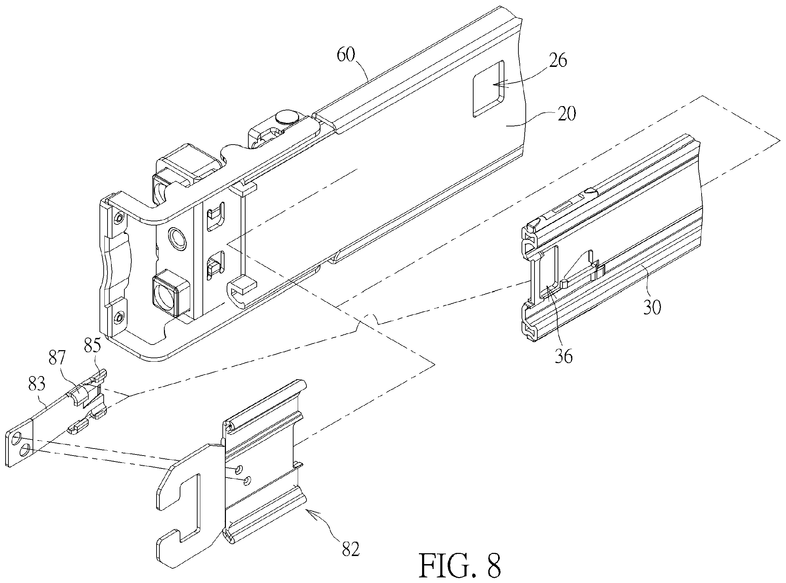

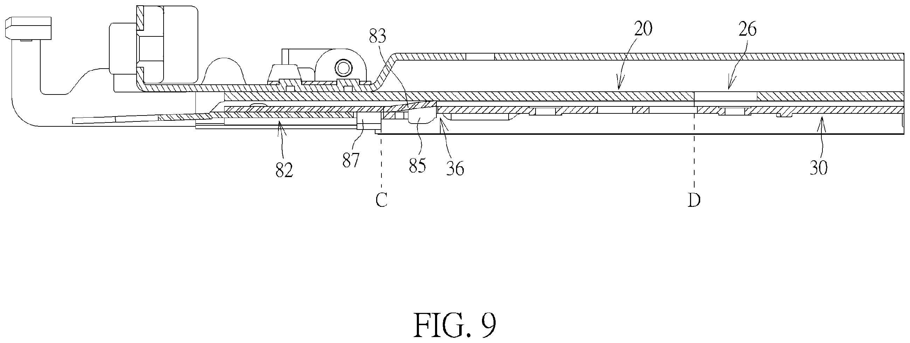

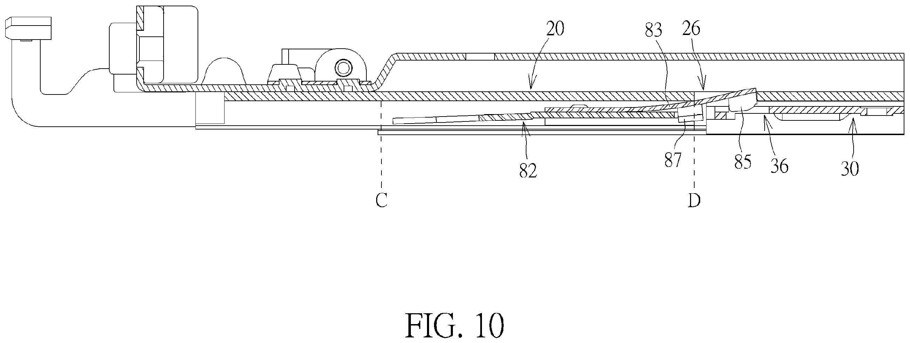

Referring to FIG. 7 and FIG. 8, FIG. 7 and FIG. 8 are diagrams showing the first connection base comprising an elastic arm for engaging with the middle rail. According to an embodiment of the present invention, the first connection base 82 can comprises an elastic arm 83, and a hook portion 85 of the elastic arm 83 can enter an opening 36 of the middle rail 30 for connecting the first connection base 82 and the middle rail 30. As shown in FIG. 9, when the first connection base 82 is not located at the position D, the elastic arm 83 is pressed to push the hook portion 85 of the elastic arm 83 into the opening 36 of the middle rail 30, such that the first connection base 82 is engaged with the middle rail 30 for moving with the middle rail 30. As shown in FIG. 10, when the first connection base 82 arrives at the position D, a releasing unit, such as a releasing hole 26 on the outer rail 20 can allow the elastic arm 83 to recover, such that the hook portion 85 of the elastic arm 83 moves out from the opening 36 of the middle rail 30 for releasing the elastic arm 83 from the middle rail 30, thus the first connection base 82 is no longer moved with the middle rail 30. Moreover, the elastic arm 83 can further comprise an abutting portion 87 configured to abut against the middle rail 30. Thus when the middle rail 30 is pushed toward the position C, the first connection base 82 can be pushed by the middle rail 30 for moving with the middle rail 30. However, the present invention is not limited to the above embodiment, the present invention can comprise other kind of structure for allowing the first connection base 82 to be connected to and released from the middle rail 30.

On the other hand, as shown in FIG. 1 and FIG. 2, the first bracket 50 can comprise two third sidewalls 52 and a third lateral wall 54 connected between the two third sidewalls 52. A third passage is defined by the two third sidewalls 52 and the third lateral wall 54 along the first direction X. The slide rail assembly 10 can further comprise a supporting base 70. The supporting base 70 comprises a first supporting portion 72 and a second supporting portion 74. The first supporting portion 72 comprises two supporting sidewalls 76 and a supporting lateral wall 78 connected between the two supporting sidewalls 76. The two supporting sidewalls 76 respectively correspond to the two second sidewalls 32 of the middle rail 30, and the supporting lateral wall 78 corresponds to the second lateral wall 34 of the middle rail 30. A supporting passage is defined by the two supporting sidewalls 76 and the supporting lateral wall 78 along the first direction X. The supporting passage corresponds to the first passage, and is configured to allow the middle rail 30 to move into the supporting passage. The second supporting portion 74 is movably connected to the first bracket 50 and is movable relative to the first bracket 50 in the third passage along the first direction X.

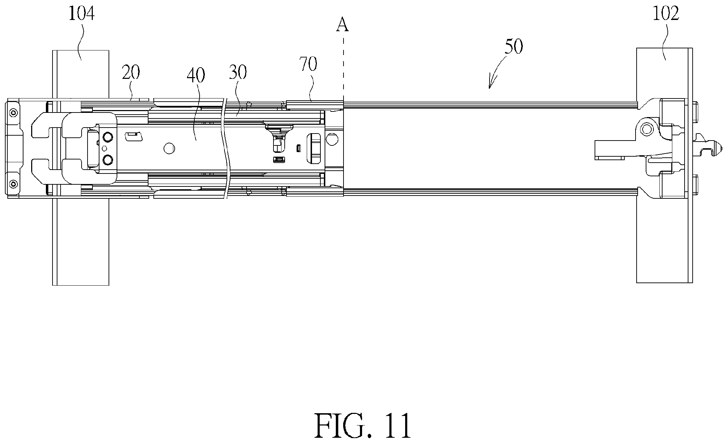

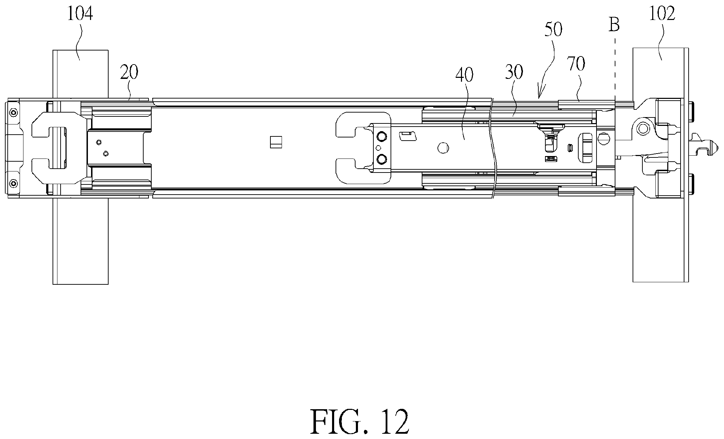

According to the above arrangement, when the chassis 90 is drawn out from the rack, the middle rail 30 moves relative to the outer rail 20 in the first passage, and a portion of the middle rail 30 moves into the supporting passage for being supported by the first supporting portion 72 of the supporting base 70. As shown in FIG. 11 and FIG. 12, the supporting base 70 can move between a position A and a position B on the first bracket 50, for supporting the middle rail 30 when the middle rail 30 is pulled out. Therefore, the middle rail 30 is supported by both the outer rail 20 and the supporting base 70, such that the slide rail assembly 10 can carry the chassis 90 more stably when the chassis 90 is drawn out from the rack.

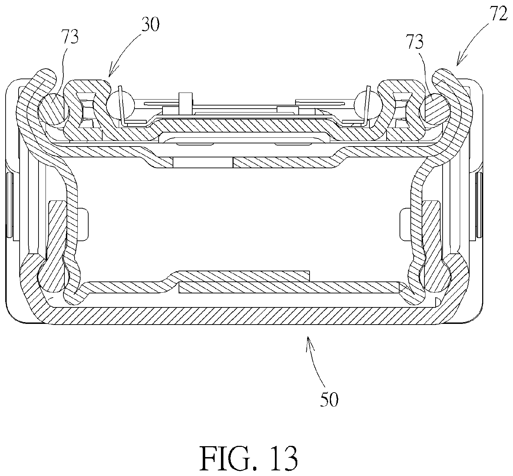

Referring to FIG. 13, FIG. 13 is a cross-sectional view of the slide rail assembly along line 1-1 of FIG. 1. The supporting base 70 can further comprise at least one contact piece 73 arranged on the first supporting portion 72. When the portion of the middle rail 30 moves into the supporting passage, the portion of the middle rail 30 contacts the contact piece 73 for driving the supporting base 70 to move along the first direction X relative to the first bracket 50. Therefore, when the chassis 90 is drawn outward, the supporting base 70 can be driven by the middle rail 30 to move to an outer position for providing better support. In other embodiment of the present invention, the supporting base 70 may not comprise the contact piece 73, that is, the supporting base 70 is not driven by the middle rail 30 to move when the chassis 90 is drawn outward. The supporting base 70 can also be moved manually.

In the above embodiment, the outer rail 20 and the first bracket 50 are integrally formed, and the outer rail 20 and the first bracket 50 are arranged at different planes along a second direction Y, where the second direction Y is perpendicular to the first direction X. According to the above arrangement, the outer rail 20 and the first bracket 50 can correspond to the shape of the chassis 90. However, the present invention is not limited to the above embodiment, the outer rail 20 and the first bracket 50 can be formed individually.

In addition, the present invention is not limited to the slide rail assembly comprising the outer rail, the middle rail and the inner rail. In other embodiment of the present invention, the middle rail can be omitted, and the inner rail can replace the middle rail to be movably connected to the outer rail and be movable relative to the outer rail in the first passage.

In contrast to the prior art, the slide rail assembly of the present invention comprises the first connection base movably arranged on the outer rail, for allowing both ends of the cable management device to move with the chassis when the chassis is drawn out from the rack. Therefore, lengths of the arms of the cable management device can be reduced, and the slide rail assembly of the present invention does not need a support member for supporting the cable management device when the travel distance of the slide rail assembly is increased.

## Claims

1. A slide rail assembly (10), comprising:
a first rail (20) defining a first passage along a first direction;
a second rail (40) capable of moving relative to the first rail (20) along the first direction;
a first connection base (82) configured to connect to a first arm (112) of a cable management device (110); and
a second connection base (84) connected to the second rail (40), and configured to connect to a second arm (114) of the cable management device (110);
**characterized by**:
the first connection base (82) is movably connected to the first rail (20)
and movable relative to the first rail (20) between a first position and
a second position in the first passage;
wherein when the second rail (40) is moved a predetermined distance outward along the first direction, the first connection base (82) is moved by the cable management device (110) from a first position toward a second position in the first passage in response to movement of the second rail (40).

2. The slide rail assembly of claim 1, **characterized in that** the first rail (20) comprises two first sidewalls (22) and
a first lateral wall (24) connected between the two first sidewalls (22), the first passage is defined by the two first sidewalls (22) and the first lateral wall (24), the slide rail assembly (10) further comprises a middle rail (30) movably connected to the first rail (20) and movable relative to the first rail (20) in the first passage, the middle rail (30) comprises two second sidewalls (32) and a second lateral wall (34) connected between the two second sidewalls (32), a second passage is defined by the two second sidewalls (32) and the second lateral wall (34) along the first direction, the second rail (40) is movably connected to the middle rail (30) and movable relative to the middle rail (30) in the second passage.

3. The slide rail assembly of claim 2, **characterized in that** the first connection base (82) comprises an elastic arm (83) configured to engage with the middle rail (30), and a releasing unit (26) is arranged on the first rail (20) for releasing the elastic arm (83) from the middle
rail (30) when the first connection base (82) is at the second position.

4. The slide rail assembly of claim 3, **characterized in that** the elastic arm (83) further comprises an abutting portion (87) configured to abut against the middle rail (30).

5. The slide rail assembly of any of claims 1-4, **characterized in that** the first rail (20) further comprises a stopper (86) for stopping the first connection base (82) when the first connection base (82) is at the second position.

6. The slide rail assembly of any of claims 1-5, **characterized in that** the slide rail assembly (10) is configured to install a chassis (90) on a rack, the chassis (90) comprises a first portion (92) and a second portion (94), the first portion (92) is wider than the second portion (94), and a side of the second portion (94) is mounted on the second rail (40).

## Patentansprüche

1. Gleitschienenaufbau (10), umfassend:
eine erste Schiene (20) die eine erste Passage entlang einer ersten Richtung definiert;
eine zweite Schiene (40), die sich relativ zu der ersten Schiene (20) entlang der ersten Richtung bewegen kann;
eine erste Verbindungsbasis (82), die ausgestaltet ist, mit einem ersten Arm (112) einer Kabelhaltevorrichtung (110) verbunden zu werden; und
eine zweite Verbindungsbasis (84), die mit der zweiten Schiene (40) verbunden und ausgestaltet ist, mit einem zweiten Arm (114) der Kabelhaltevorrichtung (110) zu verbinden;
**dadurch gekennzeichnet, dass**:
die erste Verbindungsbasis (82) mit der ersten Schiene (20) bewegbar verbunden und relativ zu der ersten Schiene (20) zwischen einer ersten Position und einer zweiten Position in der ersten Passage bewegbar ist,
worin wenn die zweite Schiene (40) eine bestimmte Entfernung nach aussen entlang der ersten Richtung bewegt wird, die erste Verbindungsbasis (82) durch die Kabelhaltevorrichtung (110) von einer ersten Position in eine zweite Position in der ersten Passage in Antwort auf die Bewegung der zweiten Schiene (40) bewegt wird.

2. Gleitschienenaufbau 1, **dadurch gekennzeichnet, dass** die erste Schiene (20) zwei erste Seitenwände (22) und eine erste seitliche Wand (24) umfasst, die zwischen den zwei ersten Seitenwänden (22) verbunden ist, worin die erste Passage durch die zwei ersten Seitenwände (22) und die erste seitliche Wand (24) definiert wird, worin der Gleitschienen-Aufbau (10) weiter eine mittlere Schiene (30) umfasst, die mit der ersten Schiene (20) bewegbar verbunden und relativ zu der ersten Schiene (20) in der ersten Passage bewegbar ist, worin die mittlere Schiene (30) zwei zweite Seitenwände (32) und eine zweite seitliche Wand (34) umfasst, die zwischen den zwei zweiten Seitenwänden (32) vebrunden ist, worin eine zweite Passage durch die zwei zweiten Seitenwände (32) und die zweite seitliche Wand (34) entlang der ersten Richtung definiert ist, worin die zweite Schiene (40) mit der mittleren Schiene (30) bewegbar verbunden und relativ zu der mittleren Schiene (30) in der zweiten Passage bewegbar ist.

3. Gleitschienenaufbau 2, **dadurch gekennzeichnet, dass** die erste Verbindungsbasis (82) einen elastischen Arm (83) umfasst, der ausgestaltet ist, mit der mittleren Schiene (30) in Eingriff zu kommen, worin eine Löseeinheit (26) an der ersten Schiene (20) angeordnet ist, um den elastischen Arm (83) von der mittleren Schiene (30) zu lösen, wenn die erste Verbindungsbasis (82) an der zweiten Position ist.

4. Gleitschienenaufbau 3, **dadurch gekennzeichnet, dass** der elastische Arm (83) weiter einen Auflagebereich (87) umfasst, der ausgestaltet ist, gegen die mittlere Schiene (30) aufzuliegen.

5. Gleitschienenaufbau nach einem der Ansprüche 1-4, **dadurch gekennzeichnet, dass** die erste Schiene (20) weiter einen Stopper (86) zum Stoppen der ersten Verbindungsbasis (82) umfasst, wenn die erste Verbindungsbasis (82) an der zweiten Position ist.

6. Gleitschienenaufbau nach einem der Ansprüche 1-5, **dadurch gekennzeichnet, dass** der Gleitschienenaufbau (10) ausgestaltet ist, eine Chassis (90) auf einem Gestell zu installieren, worin die Chassis (90) einen ersten Bereich (92) und einen zweiten Bereich (94) umfasst, worin der erste Bereich (92) weiter ist als der zweite Bereich (94), worin eine Seite des zweiten Bereichs (94) an der zweiten Schiene (40) befestigt ist.

## Revendications

1. Ensemble de glissières (10) qui comprend :
un premier rail (20) définissant un premier passage le long d'une première direction ;
un deuxième rail (40) pouvant se déplacer par rapport au premier rail (20) le long de la première direction ;
une première base de connexion (82) configurée pour se connecter à un premier bras (112) du dispositif de contrôle de câbles (110) ; et
une deuxième base de connexion (84) connectée à un deuxième rail (40), et configurée pour se connecter à un deuxième bras (114) du dispositif de contrôle des câbles (110) ;
**caractérisé par** :
la première base de connexion (82) est connectée de manière mobile au premier rail (20) et étant mobile par rapport au premier rail (20) entre la première position et la deuxième position du premier passage ;
dans lequel lorsque le deuxième rail (40) est déplacé d'une distance prédéterminée vers l'extérieur le long de la première direction, la première base de connexion (82) est déplacée par le dispositif de contrôle des câbles (110) pour passer d'une première position vers une deuxième position dans le premier passage en réponse au déplacement du deuxième rail (40).

2. Ensemble de glissières selon la revendication 1, **caractérisé en ce que** le premier rail (20) comprend deux premiers côtés latéraux (22) et une première paroi latérale (24) connectée entre les deux premiers côtés latéraux (22), le premier passage est défini par les deux premiers côtés latéraux (22) et par la première paroi latérale (24), l'ensemble de glissières (10) comprend en outre un rail intermédiaire (30) connecté de manière mobile au premier rail (20) et étant mobile par rapport au premier rail (20) dans le premier passage, le rail intermédiaire (30) comprend deux deuxièmes côtés latéraux (32) et une deuxième paroi latérale (34) connectée entre les deux deuxièmes côtés latéraux (32), un deuxième passage est défini par les deux deuxièmes côtés latéraux (32) et la deuxième paroi latérale (34) le long de la première direction, le deuxième rail (40) est connecté de manière mobile au rail intermédiaire (30) et mobile par rapport au rail intermédiaire (30) dans le deuxième passage.

3. Ensemble de glissières selon la revendication 2, **caractérisé en ce que** la première base de connexion (82) comprend un bras élastique (83) configuré pour s'engager avec le rail intermédiaire (30), et une unité de libération (26) qui est disposée sur le premier rail (20) pour libérer le bras élastique (83) du rail intermédiaire (30) lorsque la première base de connexion (82) est à la deuxième position.

4. Ensemble de glissières selon la revendication 3, **caractérisé en ce que** le bras élastique (83) comprend en outre une partie de butée (87) configurée pour buter contre le rail intermédiaire (30).

5. Ensemble de glissières selon l'une des revendications 1 à 4, **caractérisé en ce que** le premier rail (20) comprend en outre une butée (86) pour arrêter la première base de connexion (82) lorsque la première base de connexion (82) est à la deuxième position.

6. Ensemble de glissières selon l'une des revendications 1 à 5, **caractérisé en ce que** l'ensemble de glissières (10) est configuré pour installer un châssis (90) sur un portant, le châssis (90) comprend une première partie (92) et une deuxième partie (94), la première partie (92) étant plus large que la seconde partie (94), et un côté de la deuxième partie (94) étant monté sur le deuxième rail (40).
